# EUROPEAN PATENT APPLICATION

(11) **EP 4 648 268 A1**
(43) Date of publication of application: **12.11.2025**
(21) Application number: 24174815.1
(22) Date of filing: 08.05.2024
(51) Int. Cl.: H02M 1/00, G01R 19/00, H02M 3/158, H02M 1/08, H03K 17/08

(54) **SWITCHED MODE ELECTRICAL POWER SUPPLY DEVICE AND METHOD FOR OPERATING A SWITCHED MODE ELECTRICAL POWER SUPPLY DEVICE**

(71) Applicant: Infineon Technologies Austria AG, 9500 Villach (AT)
(72) Inventor: GROIß, Stefan Hermann, 9523 Landskron (AT)
(74) Representative: Stöckeler, Ferdinand

(57) **Abstract**

An electrical power supply device configured for providing a load current, the electrical power supply device comprising:
a half bridge circuit comprising a high-side power transistor and a low side power transistor;
a gate driver circuit configured to drive the high-side power transistor and the low-side power transistor alternatively in a first switching mode;
a load current sensing device, wherein the load current sensing device comprises for sensing a portion of the load current in the second switching mode a low-side sensing transistor and a low-side regulator;
a load current sensing refining device, wherein the load current sensing refining device comprises a low-side current adding device configured for adding a low-side refining current to a low-side feedback loop during the second switching mode in order to refine a low-side sensing signal for the portion of the load current in the second switching mode at the output of the low-side regulator.

## Description

### Technical Field

Embodiments relate to an electrical power supply device configured for providing a load current. More particular, the disclosure deals with a switched mode electrical power supply device.

### Background of the Invention

Switched mode electrical power supply device often comprise a half bridge circuit comprising a high-side power transistor and a low side power transistor and a gate driver circuit configured to drive the high-side power transistor and the low-side power transistor alternatively in a first switching mode, and in a second switching mode. In some applications, it is desired to measure over time a portion of the load current during the second switch mode and/or a portion of the load current during the second switch mode.

For measuring the portion of the load current during the second switch mode a low-side sensing transistor may be used which acts as a current mirror for the portion of the load current during the second switch mode. Such measure principle requires, that the potential of one of the load contacts of the low-side sensing transistor is regulated by a low-side regulator.

Similarly, for measuring the portion of the load current during the first switch mode a high-side sensing transistor may be used which acts as a current mirror for the portion of the load current during the first switch mode. Such measure principle requires, that the potential of one of the load contacts of the high-side sensing transistor is regulated by a high-side regulator.

However, in many cases the accuracy of load current measurements of prior art devices does not fulfill the requirements.

### Summary of the Invention

Disclosed is an electrical power supply device configured for providing a load current, the electrical power supply device comprising:
a half bridge circuit comprising a high-side power transistor and a low side power transistor, wherein the load current is provided at a switching node of the half bridge circuit;
a gate driver circuit configured to drive the high-side power transistor and the low-side power transistor alternatively in a first switching mode, in which the switching node is connected via the high-side power transistor to a high-side input voltage, and in a second switching mode, in which the switching node is connected via the low-side power transistor to a low-side input voltage;
a load current sensing device, wherein the load current sensing device comprises for sensing a portion of the load current in the second switching mode a low-side sensing transistor and a low-side regulator, wherein a first load contact of the low-side power transistor is connected to a first load contact of the low-side power sensing, wherein a switching contact of the low-side power transistor is connected to a switching contact of the low-side sensing transistor, wherein a second load contact of the low-side power transistor is connected to a first input of the low-side regulator, wherein a second load contact of the low-side sensing transistor is connected to a second input of the low-side regulator, wherein an output of the low-side regulator is connected to the second input of the low-side regulator in order to form a low-side feedback loop;
a load current sensing refining device, wherein the load current sensing refining device comprises a low-side current adding device configured for adding a low-side refining current to the low-side feedback loop during the second switching mode in order to refine a low-side sensing signal for the portion of the load current in the second switching mode at the output of the low-side regulator.

By the load current sensing refining device as defined above, the low-side sensing signal is much more edge (triangular) shaped as the unrefined combined sensing signal which is an improvement for whole system performance.

It is very important to mention that by this solution the properties of the low-side feedback loop (in particular the gain bandwidth of the low-side feedback loop) are not changed so that no additional risk for loop stability occurs.

According to embodiments of the disclosure, the load current sensing device comprises for sensing a portion of the load current in the first switching mode a high-side sensing transistor and a high-side regulator, wherein a first load contact of the high-side power transistor is connected to a first load contact of the high-side sensing transistor, wherein a switching contact of the high-side power transistor is connected to a switching contact of the high-side sensing transistor, wherein a second load contact of the high-side power transistor is connected to a first input of the high-side regulator, wherein a second load contact of the high-side sensing transistor is connected to a second input of the high-side regulator, wherein an output of the high-side regulator is connected to the second input of the high-side regulator in order to form a high-side feedback loop.

These features allow additionally sensing the load current during the first switching mode.

According to embodiments of the disclosure, the load current sensing refining device comprises a high-side current adding device configured for adding a high-side refining current to the high-side feedback loop during the first switching mode in order to refine a high-side sensing signal for the portion of the load current in the first switching mode at the output of the high-side regulator.

By the load current sensing refining device as defined above, the high-side sensing signal is much more edge (triangular) shaped as the unrefined combined sensing signal which is an improvement for whole system performance.

It is very important to mention that by this solution the properties of the high-side feedback loop (in particular the gain bandwidth of the high-side feedback loop) are not changed so that no additional risk for loop stability occurs.

According to embodiments of the disclosure, the load current sensing device comprises a combiner, wherein a first input of the combiner is connected to the output of the high-side regulator, and wherein a second input of the combiner is connected to the output of the low-side regulator, so that a combined sensing signal at an output of the combiner corresponds to the load current.

These features allow to monitor the load current over time over the first switching mode and over the second switching mode without gaps.

According to embodiments of the disclosure, the low-side regulator comprises an operational transconductance amplifier.

An operational transconductance amplifier (OTA) is an amplifier that outputs a current proportional to its input voltage. Thus, it is a voltage controlled current source (VCCS) which is suitable for providing the low-side sensing signal.

According to embodiments of the disclosure, the low-side current adding device comprises a digital-to-analog converter.

A digital-to-analog converter (DAC, D/A, D2A, or D-to-A) is a system that converts a digital signal into an analog signal.

These features allow to provide to the low-side current adding device information regarding the desired shape and amplitude of the low-side refining current in a digital form.

According to embodiments of the disclosure, the low-side refining current corresponds to a decaying function, in particular to a decaying exponential function.

It has been observed, that a gap between an unrefined low-side sensing signal and an ideal low-side sensing signal decreases over time. Thus, a decaying function provides an accurate compensation of the observed error.

According to embodiments of the disclosure, an amplitude and/or a shape of the decaying function of the low-side refining current is preset.

By these features, a simple structure of the device may be achieved.

According to embodiments of the disclosure, an amplitude and/or a shape of the decaying function of the low-side refining current is variably set depending on a difference of the high-side input voltage and the low-side input voltage of the half bridge circuit, a difference of an output voltage and the low-side voltage of the half bridge circuit, an output inductivity of the half bridge circuit, the load current and/or a switching frequency of the half bridge circuit.

By these features, the device may adapt the refinement procedure at the low-side automatically to changing operating parameters.

According to embodiments of the disclosure, the high-side regulator comprises an operational transconductance amplifier.

An operational transconductance amplifier (OTA) is an amplifier that outputs a current proportional to its input voltage. Thus, it is a voltage controlled current source (VCCS) which is suitable for providing the high-side sensing signal.

According to embodiments of the disclosure, the high-side current adding device comprises a digital-to-analog converter.

A digital-to-analog converter (DAC, D/A, D2A, or D-to-A) is a system that converts a digital signal into an analog signal.

These features allow to provide to the high-side current adding device information regarding the desired shape and amplitude of the high-side refining current in a digital form.

According to embodiments of the disclosure, the high-side refining current corresponds to a decaying function, in particular to a decaying exponential function.

It has been observed, that a gap between an unrefined high-side sensing signal and an ideal high-side sensing signal decreases over time. Thus, a decaying function provides an accurate compensation of the observed error.

According to embodiments of the disclosure, an amplitude and/or a shape of the decaying function of the high-side refining current is preset.

By these features, a simple structure of the device may be achieved.

According to embodiments of the disclosure, an amplitude and/or a shape of the decaying function of the high-side refining current is variably set depending on a difference of the high-side input voltage and the low-side input voltage of the half bridge circuit, a difference of an output voltage and the low-side voltage of the half bridge circuit, an output inductivity of the half bridge circuit, the load current and/or a switching frequency of the half bridge circuit.

By these features, the device may adapt the refinement procedure at the high-side automatically to changing operating parameters.

In addition, a method for operating an electrical power supply device configured for providing a load current is disclosed, wherein the electrical power supply device comprises
a half bridge circuit comprising a high-side power transistor and a low side power transistor;
a gate driver circuit;
a load current sensing device comprising a low-side sensing transistor and a low-side regulator, wherein a first load contact of the low-side power transistor is connected to a first load contact of the low-side sensing transistor, wherein a switching contact of the low-side power transistor is connected to a switching contact of the low-side sensing transistor, wherein a second load contact of the low-side power transistor is connected to a first input of the low-side regulator, wherein a second load contact of the low-side sensing transistor is connected to a second input of the low-side regulator, wherein an output of the low-side regulator is connected to the second input of the low-side regulator in order to form a low-side feedback loop; and
a load current sensing refining device, wherein the load current sensing refining device comprises a low-side current adding device;
the method comprises the steps:
   providing the load current at a switching node of the half bridge circuit;
   using the gate driver circuit for driving the high-side power transistor and the low-side power transistor alternatively in a first switching mode, in which the switching node is connected via the high-side power transistor to a high-side input voltage, and in a second switching mode, in which the switching node is connected via the low-side power transistor to a low-side input voltage;
   using the low-side sensing transistor and the low-side regulator during the second switching mode for producing a low-side sensing signal at the output of the low-side regulator, which corresponds to a portion of the load current in the second switching mode; and
   using the low-side current adding device for adding a low-side refining current to the low-side feedback loop during the second switching mode in order to refine the low-side sensing signal.

Preferred embodiments of the invention are subsequently discussed with respect to the accompanying drawings, in which:
- Figure 1: illustrates a first embodiment of an electrical power supply device according to the disclosure in a schematic view;
- Figure 2: illustrates a second embodiment of an electrical power supply device according to the disclosure in a schematic view;
- Figure 3: illustrates a third embodiment of an electrical power supply device according to the disclosure in a schematic view, wherein a low-side refining current is positive;
- Figure 4: illustrates an addition of the low-side refining current to a low-side feedback loop during a second switching mode in case that the low-side refining current is positive;
- Figure 5: illustrates a fourth embodiment of an electrical power supply device according to the disclosure in a schematic view, wherein the low-side refining current is negative;
- Figure 6: illustrates an addition of the low-side refining current to a low-side feedback loop during a second switching mode in case that the low-side refining current is negative; and
- Figure 7: illustrates an addition of the low-side refining current to a low-side feedback loop during a second switching mode in case that the low-side refining current is variable.

Equal or equivalent elements or elements with equal or equivalent functionality are denoted in the following description by equal or equivalent reference numerals.

In the following description, a plurality of details is set forth to provide a more thorough explanation of embodiments of the present disclosure. However, it will be apparent to those skilled in the art that embodiments of the present disclosure may be practiced without these specific details. In other instances, well-known structures and devices are shown in block diagram form rather than in detail in order to avoid obscuring embodiments of the present disclosure. In addition, features of the different embodiments described hereinafter may be combined with each other, unless specifically noted otherwise.

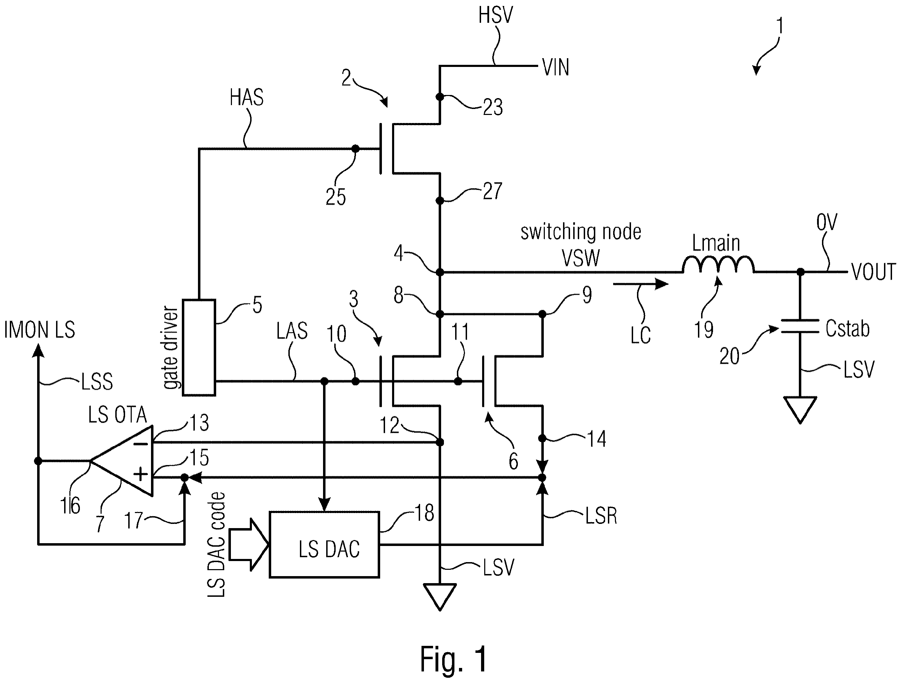

Figure 1 illustrates a first embodiment of an electrical power supply device 1 configured for providing a load current LC according to the disclosure in a schematic view. The electrical power supply device 1 comprises:
a half bridge circuit comprising a high-side power transistor 2 and a low-side power transistor 3, wherein the load current LC is provided at a switching node 4 of the half bridge circuit;
a gate driver circuit 5 configured to drive the high-side power transistor 2 and the low-side power transistor 3 alternatively in a first switching mode, in which the switching node 4 is connected via the high-side power transistor 2 to a high-side input voltage HSV, and in a second switching mode, in which the switching node 4 is connected via the low-side power transistor 3 to a low-side input voltage LSV;
a load current sensing device, wherein the load current sensing device comprises for sensing a portion of the load current LC in the second switching mode a low-side sensing transistor 6 and a low-side regulator 7, wherein a first load contact 8 of the low-side power transistor 3 is connected to a first load contact 9 of the low-side sensing transistor 6, wherein a switching contact 10 of the low-side power transistor 3 is connected to a switching contact 11 of the low-side sensing transistor 6, wherein a second load contact 12 of the low-side power transistor 3 is connected to a first input 13 of the low-side regulator 7, wherein a second load contact of the low-side sensing transistor 14 is connected to a second input 15 of the low-side regulator 7, wherein an output 16 of the low-side regulator 7 is connected to the second input 15 of the low-side regulator 7 in order to form a low-side feedback loop 17;
a load current sensing refining device, wherein the load current sensing refining device comprises a low-side current adding device 18 configured for adding a low-side refining current LSR to the low-side feedback loop 17 during the second switching mode in order to refine a low-side sensing signal LSS for the portion of the load current LC in the second switching mode at the output 16 of the low-side regulator 7.

In the first embodiment, the switching node 4 is connected via an output inductivity 19 and an output capacity 20 to the low-side input voltage LSV, wherein an output voltage OV is provided at a connection between the output inductivity 19 and the output capacity 20.

The low-side power transistor 3 and the low-side sensing transistor 6 are switched on and off by a low-side activation signal LAS from the gate driver circuit 5. The high-side power transistor 2 is switched on and off by a high-side activation signal HAS from the gate driver circuit 5.

In the first embodiment, the load current sensing device comprises for sensing a portion of the load current LC in the second switching mode a low-side sensing transistor 6 and a low-side regulator 7. The low-side sensing signal LSS corresponds to the portion of the load current LC in the second switching mode. The low-side sensing transistor 6 acts as a current mirror which mirrors the portion of the load current LC, which flows through the low-side power transistor 3 in the second switching mode.

The low-side regulator 7 is configured for regulating the potential of the second load contact 14 of the low-side sensing transistor 6, which is usually the source contact or the emitter contact of the low-side sensing transistor 6, in such way that its value is equal to the value of the potential of the second load contact 12 of the low-side power transistor 3, which is usually the source contact or the emitter contact of the low-side power transistor 3.

However, the bandwidth of the low-side regulator 7 may be limited, so that especially at higher switching frequencies after switching to the second switching mode the value of the potential of the second load contact 14 of the low-side sensing transistor 6 may significantly differ for some time from the value of the potential of the second load contact 12 of the low-side power transistor 3 so that the low-side sensing signal LSS is inaccurate to some degree.

In order to enhance the accuracy of the low-side sensing signal LSS, the low-side current adding device 18 adds a low-side refining current LSR to the low-side feedback loop 17 so that, after switching to the second switching mode, the value of the potential of the second load contact 14 of the low-side sensing transistor 6 reaches the value of the potential of the second load contact 12 of the low-side power transistor 3 much faster. In order to achieve this goal, an amplitude and a shape of the low-side refining current LSR may be defined depending on the dynamic behavior of the low-side regulator 7, the low-side feedback loop 17, the low-side power transistor 3 and the low-side sensing transistor 6. Depending on the specific case, the low-side refining current LSR may flow in the same or in the opposite direction as the current from the second load contact 14 of the low-side sensing transistor 6.

Figure 1 in addition illustrates a method for operating an electrical power supply device 1 configured for providing a load current LC, wherein the electrical power supply device 1 comprises
a half bridge circuit comprising a high-side power transistor 2 and a low side power transistor 3;
a gate driver circuit 5;
a load current sensing device comprising a low-side sensing transistor 6 and a low-side regulator 7, wherein a first load contact 8 of the low-side power transistor 3 is connected to a first load contact 9 of the low-side sensing transistor 6, wherein a switching contact 10 of the low-side power transistor 3 is connected to a switching contact 11 of the low-side sensing transistor 6, wherein a second load contact 12 of the low-side power transistor 3 is connected to a first input 13 of the low-side regulator 7, wherein a second load contact 14 of the low-side sensing transistor 6 is connected to a second input 15 of the low-side regulator 7, wherein an output 16 of the low-side regulator 7 is connected to the second input 15 of the low-side regulator 7 in order to form a low-side feedback loop 17; and
a load current sensing refining device, wherein the load current sensing refining device comprises a low-side current adding device 18;
wherein the method comprises the steps:
   providing the load current LC at a switching node 4 of the half bridge circuit;
   using the gate driver circuit 5 for driving the high-side power transistor 2 and the low-side power transistor 3 alternatively in a first switching mode, in which the switching node 4 is connected via the high-side power transistor 2 to a high-side input voltage HSV, and in a second switching mode, in which the switching node 4 is connected via the low-side power transistor 3 to a low-side input voltage LSV;
   using the low-side sensing transistor 6 and the low-side regulator 7 during the second switching mode for producing a low-side sensing signal LSS at the output 16 of the low-side regulator 7, which corresponds to a portion of the load current LC in the second switching mode; and
   using the low-side current adding device 18 for adding a low-side refining current LSR to the low-side feedback loop 17 during the second switching mode in order to refine the low-side sensing signal LSS.

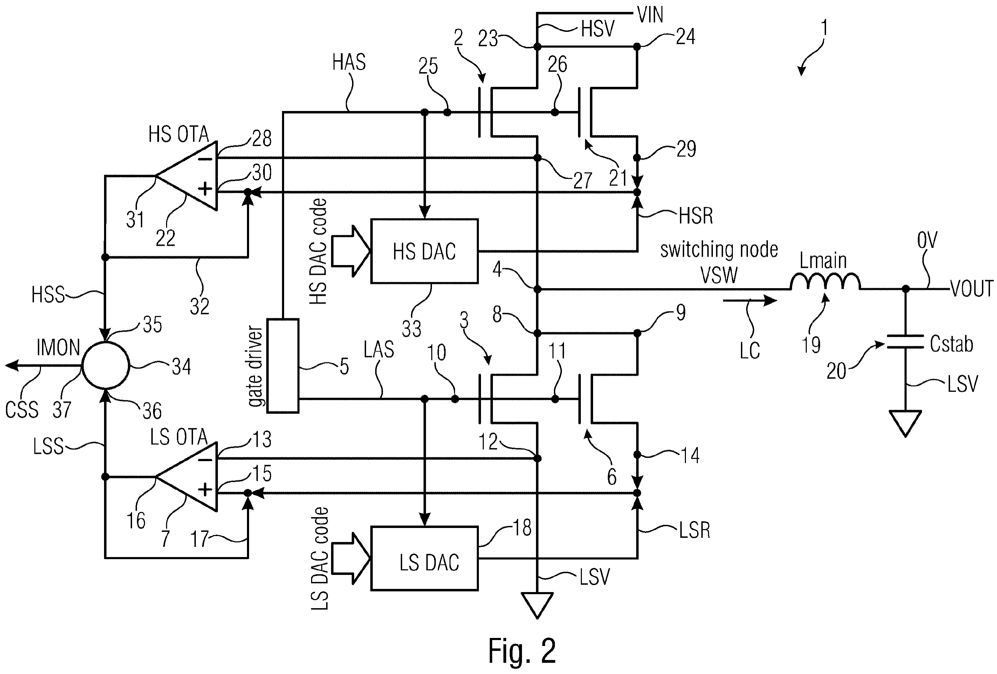

Figure 2 illustrates a second embodiment of an electrical power supply device 1 configured for providing a load current LC according to the disclosure in a schematic view. The second embodiment is based on the first embodiment, so that in the following only the differences of the second embodiment are discussed.

According to embodiments of the disclosure, the load current sensing device comprises for sensing a portion of the load current LC in the first switching mode a high-side sensing transistor 21 and a high-side regulator 22, wherein a first load contact 23 of the high-side power transistor 2 is connected to a first load contact 24 of the high-side sensing transistor 21, wherein a switching contact 25 of the high-side power transistor 2 is connected to a switching contact 26 of the high-side sensing transistor 21, wherein a second load contact 27 of the high-side power transistor 2 is connected to a first input 28 of the high-side regulator 22, wherein a second load contact 29 of the high-side sensing transistor 21 is connected to a second input 30 of the high-side regulator 22, wherein an output 31 of the high-side regulator 22 is connected to the second input 30 of the high-side regulator 22 in order to form a high-side feedback loop 32.

According to embodiments of the disclosure, the load current sensing refining device comprises a high-side current adding device 33 configured for adding a high-side refining current HSR to the high-side feedback loop 32 during the first switching mode in order to refine a high-side sensing signal HSS for the portion of the load current LC in the first switching mode at the output 31 of the high-side regulator 22.

According to embodiments of the disclosure, the load current sensing device comprises a combiner 34, wherein a first input 35 of the combiner 34 is connected to the output 31 of the high-side regulator 22, and wherein a second input 36 of the combiner 34 is connected to the output 16 of the low-side regulator 7, so that a combined sensing signal CSS at an output of the combiner corresponds to the load current LC.

According to embodiments of the disclosure, the low-side regulator 7 comprises an operational transconductance amplifier.

According to embodiments of the disclosure, the low-side current adding device 18 comprises a digital-to-analog converter.

According to embodiments of the disclosure, the low-side refining current LSR corresponds to a decaying function, in particular to a decaying exponential function.

According to embodiments of the disclosure, an amplitude and/or a shape of the decaying function of the low-side refining current LSR is preset.

According to embodiments of the disclosure, an amplitude and/or a shape of the decaying function of the low-side refining current LSR is variably set depending on a difference of the high-side input voltage HSV and the low-side input voltage LSV of the half bridge circuit, a difference of an output voltage OV and the low-side input voltage LSV of the half bridge circuit, an output inductivity 19 of the half bridge circuit, the load current LC and/or a switching frequency of the half bridge circuit.

According to embodiments of the disclosure, the high-side regulator 22 comprises an operational transconductance amplifier.

According to embodiments of the disclosure, the high-side current adding device 33 comprises a digital-to-analog converter.

According to embodiments of the disclosure, the high-side refining current HSR corresponds to a decaying function, in particular to a decaying exponential function.

According to embodiments of the disclosure, an amplitude and/or a shape of the decaying function of the high-side refining current HSR is preset.

According to embodiments of the disclosure, an amplitude and/or a shape of the decaying function of the high-side refining current HSR is variably set depending on a difference of the high-side input voltage HSV and the low-side input voltage LSV of the half bridge circuit, a difference of an output voltage OV and the low-side input voltage LSV of the half bridge circuit, an output inductivity 19 of the half bridge circuit, the load current LC and/or a switching frequency of the half bridge circuit.

In the second embodiment, the high-side sensing transistor 21 is switched on and off by the high-side activation signal HAS from the gate driver circuit 5.

The load current sensing device additionally comprises for sensing a portion of the load current LC in the first switching mode a high-side sensing transistor 21 and a high-side regulator 22. The high-side sensing signal HSS corresponds to the portion of the load current LC in the first switching mode. The high-side sensing transistor 21 acts as a current mirror which mirrors the portion of the load current LC, which flows through the high-side power transistor 2 in the first switching mode.

The high-side regulator 22 is configured for regulating the potential of the second load contact 29 of the high-side sensing transistor 21, which is usually the source contact or the emitter contact of the high-side sensing transistor 21, in such way that its value is equal to the value of the potential of the second load contact 27 of the high-side power transistor 2, which is usually the source contact or the emitter contact of the high-side power transistor 2.

Similar to the bandwidth of the low-side regulator 7, the bandwidth of the high-side regulator 22 may be limited, so that especially at higher switching frequencies after switching to the first switching mode the value of the potential of the second load contact 29 of the high-side sensing transistor 21 may significantly differ for some time from the value of the potential of the second load contact 27 of the high-side power transistor 2 so that the high-side sensing signal HSS is inaccurate to some degree.

In order to enhance the accuracy of the high-side sensing signal HSS, the high-side current adding device 33 adds a high-side refining current HSR to the high-side feedback loop 32 so that, after switching to the first switching mode, the value of the potential of the second load contact 29 of the high-side sensing transistor 21 reaches the value of the potential of the second load contact 27 of the high-side power transistor 2 much faster. In order to achieve this goal, an amplitude and a shape of the high-side refining current HSR may be defined depending on the dynamic behavior of the high-side regulator 22, the high-side feedback loop 32, the high-side power transistor 2 and the high-side sensing transistor 21. Depending on the specific case, the high-side refining current HSR may flow in the same or in the opposite direction as the current from the second load contact 29 of the high-side sensing transistor 21.

The combiner 37 combines the high-side sensing signal HSS and low-side sensing signal LSS in such way, that during the first switch mode the combined sensing signal CSS is equal to the high-side sensing signal HSS, and that during the second switch mode the combined sensing signal CSS is equal to the low-side sensing signal LSS.

In a modification of the second embodiment, the high-side current adding device 33 is omitted, so that only the low-side sensing signal LSS is refined.

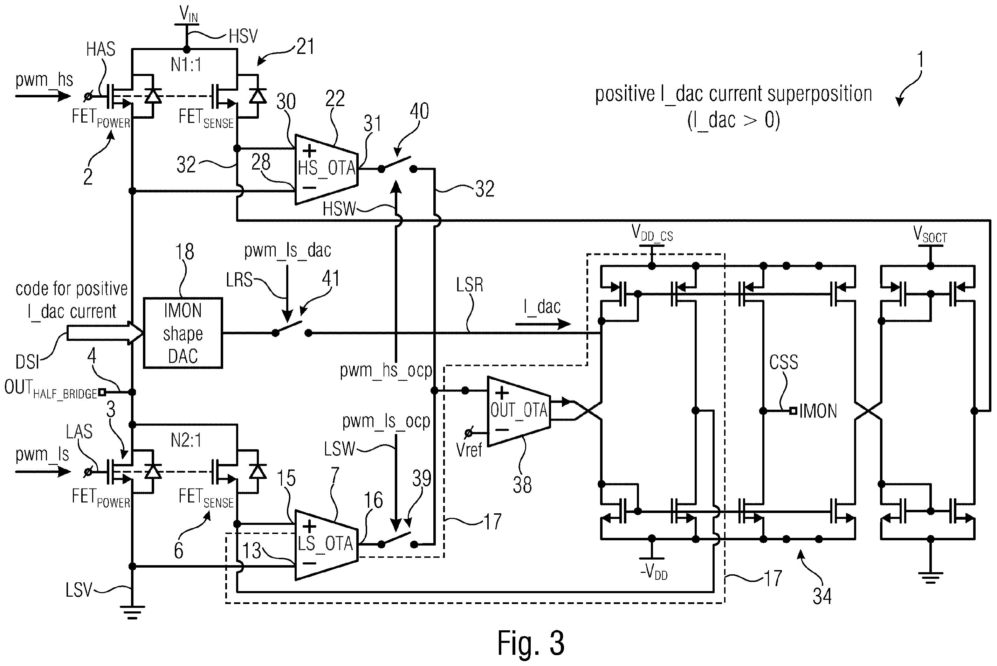

Figure 3 illustrates a third embodiment of an electrical power supply device according to the disclosure in a schematic view, wherein a low-side refining current is positive. The third embodiment is based on the first embodiment, so that in the following only the differences of the second embodiment are discussed.

In the third embodiment, each of the high-side power transistor 2, the low-side power transistor 3, low-side sensing transistor 6 and the high-side sensing transistor 21 is a field effect transistor. However, transistors of a different type could be used.

In order that current sense principle works highly accurate it is necessary that the source potentials of the high-side power transistor 2 and high-side sensing transistor 21 are regulated to the same value. In the same way, it is necessary that the source potentials of the low-side power transistor 3 and low-side sensing transistor 6 are regulated to the same value. Otherwise, the high-side power transistor 2 and high-side sensing transistor 21 (or the low-side power transistor 3 and low-side sensing transistor 6) do not work as accurate current mirror. The fraction of load current which is flowing out or into the sources of the sensing transistors 6, 21 is controlled for high-side operation by high-side regulator 22 and a main amplifier 38 and for low-side operation by the low-side regulator 7 and the main amplifier 38. In order to reach high accuracy, the input offset of high-side regulator 22 and low-side regulator 7 must be very small. The high-side feedback loop 32 and the low-side feedback loop17 are closed by current sinks / sources which are providing the actual sense current in order to regulate the sources of the power transistors 2, 3 and the sources of the assigned sensing transistors 6, 21 to the same potential.

By choice of proper circuitry dimensioning combined sensing signal CSS can be set to a desired sensitivity, for example, the combined sensing signal CSS can be set to a value of 5pA for a value of 1A of the load current LC.

In the third embodiment, the low-side power transistor 3 and the low-side sensing transistor 6 are switched on and off by the low-side activation signal LAS from the gate driver circuit 5 (not shown). The high-side power transistor 2 and the high-side sensing transistor 21 are switched on and off by the high-side activation signal HAS from the gate driver circuit 5 (not shown). When switching from the low-side activation signal LAS to the high-side activation signal HAS (or vice versa) a dead time may be applied in order to ensure smooth transitions, which should prevent shoot through of power stage.

The third embodiment further comprises a high-side switch 40 and a low-side switch 39. The high side feedback loop 32 is switched on and off by a high-side switch signal HSW for switching the high-side switch 40 while the low-side feedback loop 17 is switched on and off by a low-side switch signal LSW for switching the low-side switch 39. In order to eliminate influence of the package parasitics to the performance of the current sensing, the high-side feedback loop 32 and low-side feedback loop 17 may be closed after high-side resp. low-side dead time which can be in the range of typ. 35ns and is depending on used package type (chip embedding or QFN with bond wires).

A low-side refinement current switch 41 is switched by a low-side refinement signal LRS and is used for activating/deactivating the low-side refining current LSR. The shape and the amplitude of the low-side refining current LSR is defined by a definition signal DSI provided to the low-side current adding device 18. In the case of the third embodiment, the amplitude of the low-side refining current LSR is positive.

A switching frequency for switching from the first switching mode to the second switching mode may be in the range of 1 MHz to 10 MHz.

As in typical applications duty cycles of 10% - 25% are used for most of the cases for a buck converter the interval of the first switching mode is comparable short and the tracking performance of the load current sensing device is not in the focus for that phase. However, in other cases a refinement of the measurements in the first switching mode may be relevant.

As the interval of the second switching mode is much longer it dominates the accuracy performance of the load current sensing device and therefore very precise tracking of the load current LC during the second switching mode is required. Due to limited gain band width of the low-side feedback loop 17 (same is valid for a possible high-side feedback loop 32) some settling event occurs at the beginning of each switching phase. The settling event lasts the longer the smaller the gain band width of the considered feedback loop 17, 32 is.

This limitation of gain band width has an influence on the performance of the load current sensing device especially if higher switching frequencies are applied (e.g. 3MHz). If a typical value for gain band width of low-side feedback loop 17 is 10MHz then such a settling event can last some 10ns until the low-side sensing signal LSS tacks the load current LC. Therefore, such a settling event can last very long compared to the switching cycle duration (333ns for 3MHz switching frequency) which may decrease low-side sensing signal LSS and/or high-side sensing signal HSS accuracy performance.

In order to gain better settling performance one state of the art way is to increase the gain band width of the regulators 7, 22 and the main amplifier 38 but this measure costs more current consumption of the load current sensing device. As in most of the cases standard CMOS process is used for the regulators 7, 22 and the main amplifier 38, an increase for example of the factor two for gain band width costs four times more bias current for the regulator 7, 22 and main amplifier 38 input pair as in CMOS transistors transconductance is proportional to square root of drain current.

Additionally loop stability problems may occur by increasing gain band width in a closed regulation loop which is a severe disadvantage.

In the present disclosure there is presented a new concept where especially during the longer lasting low-side settling event an additional low-side refinement current LSR is added to the low-side feedback loop 17 (and/or an additional high-side refinement current HSR is added to the high-side feedback loop 32. This additional low-side refinement current LSR (and/or high-side refinement current HSR) may have itself a shape of a decaying exponential function and can advantageously be set by a DAC (digital to analog converter) in amplitude (positive and negative) and timing performance (time constant of decaying exponential function).

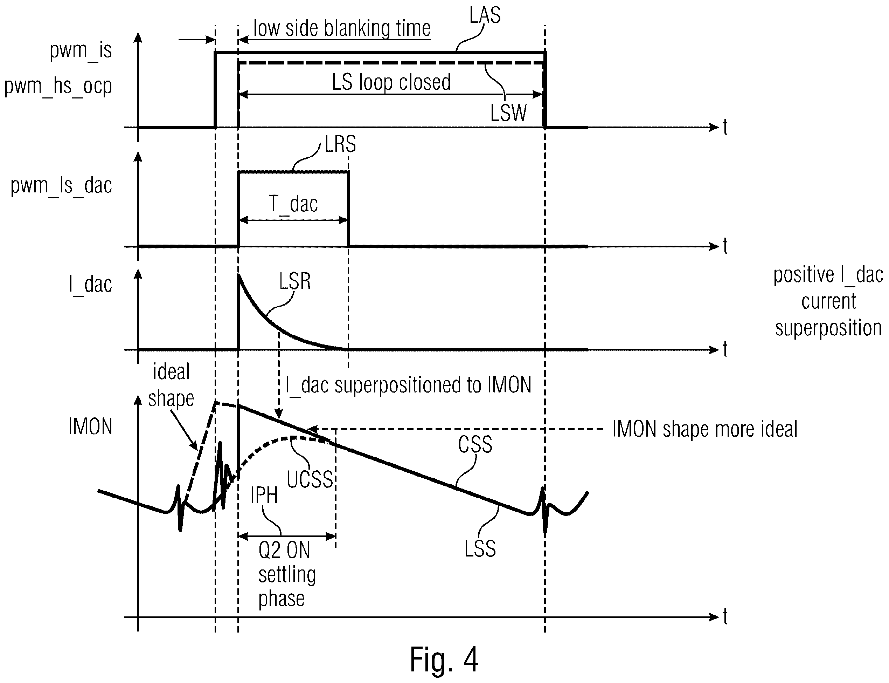

Figure 4 illustrates an addition of the low-side refining current to a low-side feedback loop during a second switching mode in case that, as in Figure 3, the low-side refining current LSR is positive. In particular, Figure 4 illustrates over time the low-side activation signal LAS, the low-side switch signal LSW, the low-side refinement signal LRS, the low-side refining current LSR, which has a positive amplitude, and the combined sensing signal CSS, which is, during the second switching mode, the low-side sensing signal LSS.

Furthermore, Figure 4 shows an unrefined combined sensing signal UCSS, which would be observed without the disclosed refinement technology disclosed herein. The combined sensing signal CSS is, during an initial phase IPH of the interval, in which the low-side feedback loop is closed, much closer to an ideal shape than the unrefined combined sensing signal UCSS.

Since the low-side refining current LSR is positive, the unrefined combined sensing signal UCSS, which is smaller than the ideal signal, is corrected, so that the combined sensing signal CSS is more accurate.

By this measure the combined sensing signal CSS is much more edge (triangular) shaped as the unrefined combined sensing signal UCSS which is an improvement for whole system performance.

It is very important to mention that by this measure the loop properties are not changed so that no additional risk for loop stability occurs.

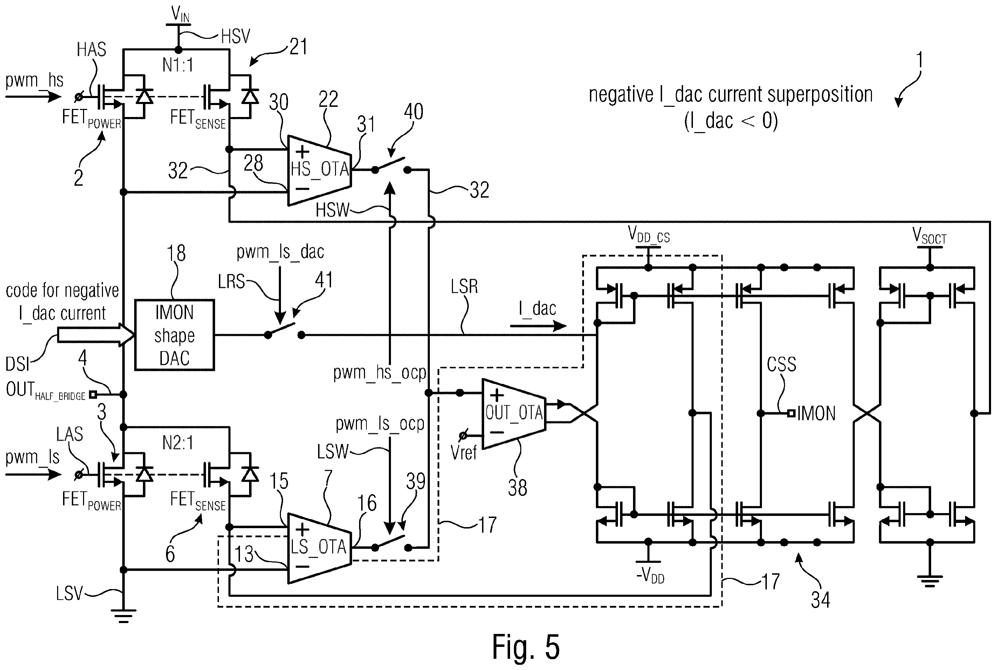

Figure 5 illustrates a fourth embodiment of an electrical power supply device according to the disclosure in a schematic view, wherein the low-side refining current is negative. The fourth embodiment is based on the third embodiment, so that in the following only the differences of the second embodiment are discussed.

The main difference between the third embodiment and the fourth embodiment is, that in the latter, the amplitude of the low-side refining current LSR is negative.

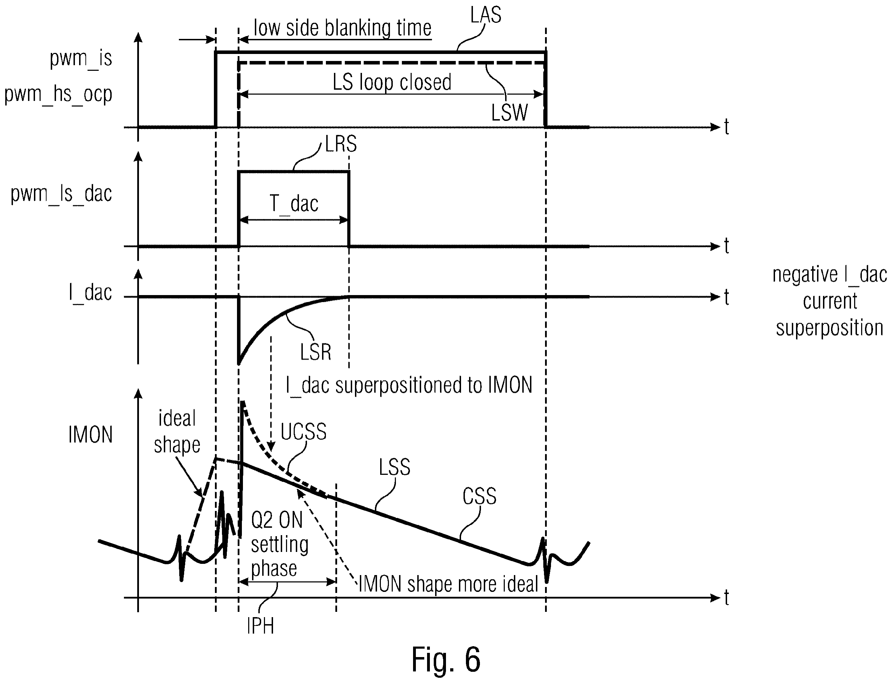

Figure 6 illustrates an addition of the low-side refining current to a low-side feedback loop during a second switching mode in case that, as in Figure 5, the low-side refining current LSR is negative. In particular, Figure 6 illustrates over time the low-side activation signal LAS, the low-side switch signal LSW, the low-side refinement signal LRS, the low-side refining current LSR, which has a positive amplitude, and the combined sensing signal CSS, which is, during the second switching mode, the low-side sensing signal LSS.

Furthermore, Figure 6 shows an unrefined combined sensing signal UCSS, which would be observed without the disclosed refinement technology disclosed herein. The combined sensing signal CSS is, during an initial phase IPH of the interval, in which the low-side feedback loop is closed, much closer to an ideal shape than the unrefined combined sensing signal UCSS.

The main difference between Figure 4 and Figure 6 is, that in the latter, the amplitude of the low-side refining current LSR is negative.

Since the low-side refining current LSR is negative, the unrefined combined sensing signal UCSS, which is larger than the ideal signal, is corrected, so that the combined sensing signal CSS is more accurate.

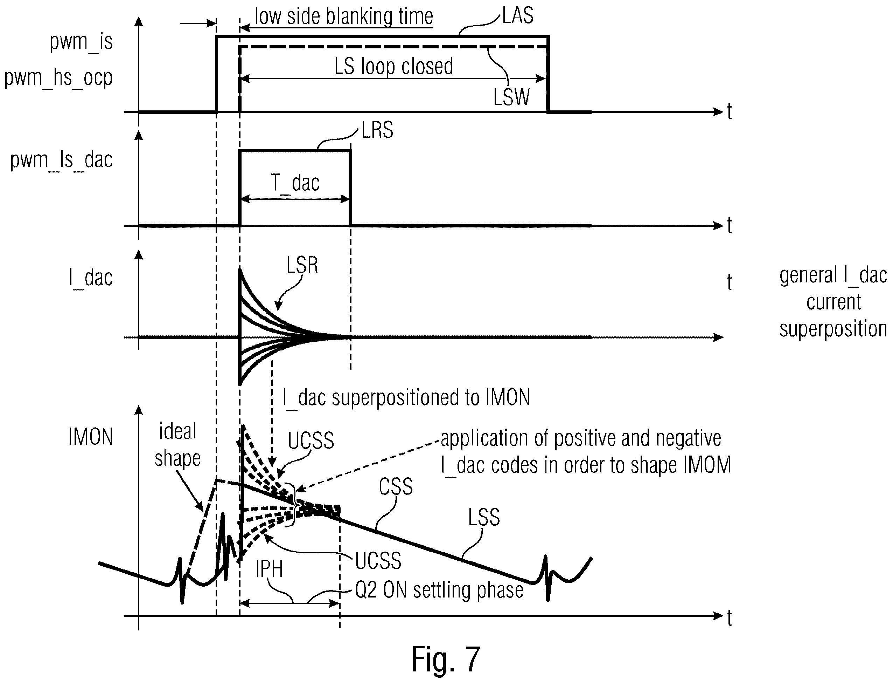

Figure 7 illustrates an addition of the low-side refining current to a low-side feedback loop during a second switching mode in case that the low-side refining current LSR is variable. In particular, Figure 7 illustrates over time the low-side activation signal LAS, the low-side switch signal LSW, the low-side refinement signal LRS, a plurality of possible shapes of the low-side refining current LSR, which have positive or negative amplitudes, and the combined sensing signal CSS, which is, during the second switching mode, the low-side sensing signal LSS.

Furthermore, Figure 7 shows a plurality of possible shapes of unrefined combined sensing signal UCSS, which would be observed without the disclosed refinement technology disclosed herein. The combined sensing signal CSS is, during an initial phase IPH of the interval, in which the low-side feedback loop is closed, much closer to an ideal shape than the unrefined combined sensing signal UCSS.

The main difference between Figures 4 and 6 on one hand and Figure 7 on the other hand is, that in the latter, the amplitude of the low-side refining current LSR is variable.

Since the low-side refining current LSR is variable, the unrefined combined sensing signal UCSS may corrected by choosing that shape for the low-side refining current LSR, which is suitable for the eventual shape of the unrefined combined sensing signal UCSS, so that the combined sensing signal CSS is more accurate.

It is important to note, that the explanations made with reference so Figures 3 to 7 for the refinement of the low-side sensing signal LSS are also valid for the refinement of the high-side sensing signal HSS, which is mentioned above with reference to Figure 2.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The above described is merely illustrative, and it is understood that modifications and variations of the arrangements and the details described herein will be apparent to others skilled in the art. It is the intent, therefore, to be limited only by the scope of the impending claims and not by the specific details presented by way of description and explanation above.

## Claims

1. An electrical power supply device configured for providing a load current (LC), the electrical power supply device (1) comprising:
a half bridge circuit comprising a high-side power transistor (2) and a low-side power transistor (3), wherein the load current (LC) is provided at a switching node (4) of the half bridge circuit;
a gate driver circuit (5) configured to drive the high-side power transistor (2) and the low-side power transistor (3) alternatively in a first switching mode, in which the switching node (4) is connected via the high-side power transistor (2) to a high-side input voltage (HSV), and in a second switching mode, in which the switching node (4) is connected via the low-side power transistor (3) to a low-side input voltage (LSV);
a load current sensing device, wherein the load current sensing device comprises for sensing a portion of the load current (LC) in the second switching mode a low-side sensing transistor (6) and a low-side regulator (7), wherein a first load contact (8) of the low-side power transistor (3) is connected to a first load contact (9) of the low-side sensing transistor (6), wherein a switching contact (10) of the low-side power transistor (3) is connected to a switching contact (11) of the low-side sensing transistor (6), wherein a second load contact (12) of the low-side power transistor (3) is connected to a first input (13) of the low-side regulator (7), wherein a second load contact of the low-side sensing transistor (14) is connected to a second input (15) of the low-side regulator (7), wherein an output (16) of the low-side regulator (7) is connected to the second input (15) of the low-side regulator (7) in order to form a low-side feedback loop (17);
a load current sensing refining device, wherein the load current sensing refining device comprises a low-side current adding device (18) configured for adding a low-side refining current (LSR) to the low-side feedback loop (17) during the second switching mode in order to refine a low-side sensing signal (LSS) for the portion of the load current (LC) in the second switching mode at the output (16) of the low-side regulator (7).

2. The electrical power supply device according to the previous claim, wherein the load current sensing device comprises for sensing a portion of the load current (LC) in the first switching mode a high-side sensing transistor (21) and a high-side regulator (22), wherein a first load contact (23) of the high-side power transistor (2) is connected to a first load contact (24) of the high-side sensing transistor (21), wherein a switching contact (25) of the high-side power transistor (2) is connected to a switching contact (26) of the high-side sensing transistor (21), wherein a second load contact (27) of the high-side power transistor (2) is connected to a first input (28) of the high-side regulator (22), wherein a second load contact (29) of the high-side sensing transistor (21) is connected to a second input (30) of the high-side regulator (22), wherein an output (31) of the high-side regulator (22) is connected to the second input (30) of the high-side regulator (22) in order to form a high-side feedback loop (32).

3. The electrical power supply device according to the previous claim, wherein the load current sensing refining device comprises a high-side current adding device (33) configured for adding a high-side refining current (HSR) to the high-side feedback loop (32) during the first switching mode in order to refine a high-side sensing signal (HSS) for the portion of the load current (LC) in the first switching mode at the output (31) of the high-side regulator (22).

4. The electrical power supply device according to claim 2 or 3, wherein the load current sensing device comprises a combiner (34), wherein a first input (35) of the combiner (34) is connected to the output (31) of the high-side regulator (22), and wherein a second input (36) of the combiner (34) is connected to the output (16) of the low-side regulator (7), so that a combined sensing signal (CSS) at an output of the combiner corresponds to the load current (LC).

5. The electrical power supply device according to one of the previous claims, wherein the low-side regulator (7) comprises an operational transconductance amplifier.

6. The electrical power supply device according to one of the previous claims, wherein the low-side current adding device (18) comprises a digital-to-analog converter.

7. The electrical power supply device according to one of the previous claims, wherein the low-side refining current (LSR) corresponds to a decaying function, in particular to a decaying exponential function.

8. The electrical power supply device according to the previous claim, wherein an amplitude and/or a shape of the decaying function of the low-side refining current (LSR) is preset.

9. The electrical power supply device according to claim 7, wherein an amplitude and/or a shape of the decaying function of the low-side refining current (LSR) is variably set depending on a difference of the high-side input voltage (HSV) and the low-side input voltage (LSV) of the half bridge circuit, a difference of an output voltage (OV) and the low-side input voltage (LSV) of the half bridge circuit, an output inductivity (19) of the half bridge circuit, the load current (LC) and/or a switching frequency of the half bridge circuit.

10. The electrical power supply device according to one of the claims 2 to 9, wherein the high-side regulator (22) comprises an operational transconductance amplifier.

11. The electrical power supply device according to one of the claims 3 to 10, wherein the high-side current adding device (33) comprises a digital-to-analog converter.

12. The electrical power supply device according to one of the claims 3 to 11, wherein the high-side refining current (HSR) corresponds to a decaying function, in particular to a decaying exponential function.

13. The electrical power supply device according to the previous claim, wherein an amplitude and/or a shape of the decaying function of the high-side refining current (HSR) is preset.

14. The electrical power supply device according to claim 12, wherein an amplitude and/or a shape of the decaying function of the high-side refining current (HSR) is variably set depending on a difference of the high-side input voltage (HSV) and the low-side input voltage (LSV) of the half bridge circuit, a difference of an output voltage (OV) and the low-side input voltage (LSV) of the half bridge circuit, an output inductivity (19) of the half bridge circuit, the load current (LC) and/or a switching frequency of the half bridge circuit.

15. A method for operating an electrical power supply device (1) configured for providing a load current (LC), wherein the electrical power supply device (1) comprises
a half bridge circuit comprising a high-side power transistor (2) and a low side power transistor (3);
a gate driver circuit (5);
a load current sensing device comprising a low-side sensing transistor (6) and a low-side regulator (7), wherein a first load contact (8) of the low-side power transistor (3) is connected to a first load contact (9) of the low-side sensing transistor (6), wherein a switching contact (10) of the low-side power transistor (3) is connected to a switching contact (11) of the low-side sensing transistor (6), wherein a second load contact (12) of the low-side power transistor (3) is connected to a first input (13) of the low-side regulator (7), wherein a second load contact (14) of the low-side sensing transistor (6) is connected to a second input (15) of the low-side regulator (7), wherein an output (16) of the low-side regulator (7) is connected to the second input (15) of the low-side regulator (7) in order to form a low-side feedback loop (17); and
a load current sensing refining device, wherein the load current sensing refining device comprises a low-side current adding device (18);
the method comprises the steps:
providing the load current (LC) at a switching node (4) of the half bridge circuit;
using the gate driver circuit (5) for driving the high-side power transistor (2) and the low-side power transistor (3) alternatively in a first switching mode, in which the switching node (4) is connected via the high-side power transistor (2) to a high-side input voltage (HSV), and in a second switching mode, in which the switching node (4) is connected via the low-side power transistor (3) to a low-side input voltage (LSV);
using the low-side sensing transistor (6) and the low-side regulator (7) during the second switching mode for producing a low-side sensing signal (LSS) at the output (16) of the low-side regulator (7), which corresponds to a portion of the load current (LC) in the second switching mode; and
using the low-side current adding device (18) for adding a low-side refining current (LSR) to the low-side feedback loop (17) during the second switching mode in order to refine the low-side sensing signal (LSS).
